# EUROPEAN PATENT APPLICATION

(11) **EP 4 783 775 A1**
(43) Date of publication of application: **29.07.2026**
(21) Application number: 26153021.6
(22) Date of filing: 20.01.2026
(51) Int. Cl.: H10F 10/16, H10F 77/12, H10F 77/30

(54) **SOLAR CELL**

(30) Priority: 23.01.2025 JP 2025009581
(71) Applicant: KABUSHIKI KAISHA TOSHIBA, Kawasaki-shi, Kanagawa 212-0013 (JP)
(72) Inventor: YAMAMOTO, Takashi, Kawasaki-shi, Kanagawa (JP); SHIBASAKI, Soichiro, Kawasaki-shi, Kanagawa (JP); SUGIMOTO, Kanta, Kawasaki-shi, Kanagawa (JP); YAMAMOTO, Kazushige, Kawasaki-shi, Kanagawa (JP)
(74) Representative: Hoffmann Eitle

(57) **Abstract**

A solar cell according to an embodiment includes a first transparent electrode, a p-type light absorbing layer provided on the first transparent electrode, a first n-type layer provided on the p-type light absorbing layer, a second n-type layer provided on the first n-type layer, a second transparent electrode provided on the second n-type layer, and an antireflection layer provided on the second transparent electrode. The refractive index of the second n-type layer is higher than the refractive index of the first n-type layer. The second n-type layer comprises a titanium-including metal oxide.

## Description

### FIELD

Embodiments described herein relate generally to a solar cell, a multi-junction solar cell, a solar cell module, and a photovoltaic power generation system.

### BACKGROUND

One-type of new solar cell uses copper (I) oxide (Cu₂O) as the light-absorbing layer. Cu₂O is a wide-bandgap semiconductor. Because Cu₂O is a safe and inexpensive material composed of copper and oxygen, which are abundantly available on Earth, it is expected that high-efficiency and low-cost solar cells can be realized.

### BRIEF DESCRIPTION OF THE DRAWINGS

FIG. 1 is a schematic cross-sectional diagram of a solar cell according to an embodiment;
FIG. 2 is a diagram explaining the analysis spots of the solar cell according to an embodiment;
FIG. 3 is a cross-sectional diagram of a multi junction solar cell according to an embodiment;
FIG. 4 is a perspective schematic diagram of a solar cell module according to an embodiment;
FIG. 5 is a perspective schematic diagram of a solar cell module according to an embodiment;
FIG. 6 is a configuration diagram of a photovoltaic power generation system according to an embodiment;
FIG. 7 is a schematic diagram of a vehicle according to an embodiment;
FIG. 8 is a schematic diagram of a drone according to an embodiment;
FIG. 9 is a table of Examples;
FIG. 10 is a table of Examples;
FIG. 11 is a table of Examples;
FIG. 12 is a table of Examples;
FIG. 13 is a table of Examples; and
FIG. 14 is a table of Examples.

### DETAILED DESCRIPTION

A solar cell according to an embodiment includes a first transparent electrode, a p-type light absorbing layer provided on the first transparent electrode, a first n-type layer provided on the p-type light absorbing layer, a second n-type layer provided on the first n-type layer, a second transparent electrode provided on the second n-type layer, and an anti-reflection layer provided on the second transparent electrode. The refractive index of the second n-type layer is higher than the refractive index of the first n-type layer. The second n-type layer comprises a titanium-including metal oxide.

Hereinafter, referring to the drawings, the embodiments of the present invention will be described in detail.

With reference to the drawings, a preferred embodiment of the present invention will be described in detail. Unless otherwise specifically indicated, the physical property values shown are those measured at 25 °C and 1 atm (atmospheric pressure). "Average" denotes an arithmetic mean. Each concentration is the average concentration in the region or layer concerned. In any layer, "a specific element is contained (included)" means that the element has been confirmed to exist, for example, by secondary ion mass spectrometry (SIMS); "a specific element is not contained" means that the element could not be confirmed, for example, by SIMS.

In the specification, "/" denotes the division sign. However, in the expression "or/and" the "/" means "or". In the specification, "·" and "*" denote multiplication. In the specification, "." denotes a decimal point.

The thickness and structure of members described in the specification can be known, for example, from one or more of images obtained by SEM (Scanning Electron Microscope), TEM (Transmission Electron Microscope), HAADF-STEM (High-Angle Annular Dark Field Scanning Transmission Electron Microscopy), and the like. The boundaries of the members described in the specification can be determined from one or more images obtained by scanning electron microscopy or transmission electron microscopy, SEM-EDX (Scanning Electron Microscopy with Energy Dispersive X-ray Spectroscopy) or TEM-EDX (Transmission Electron Microscopy with Energy Dispersive X-ray Spectroscopy), SIMS (Secondary Ion Mass Spectrometry), and the like. The composition of the members described in the specification can be determined by one SIMS, ICP-MS (Inductively Coupled Plasma Mass Spectrometry), SEM-EDX, TEM-EDX, or the like. The crystallinity of the members described in the specification can be evaluated, for example, from XRD (X-ray Diffraction), EBSD (Electron Backscatter Diffraction), images obtained by HAADF-STEM, SEM, TEM or the like. Materials included in the members described in the specification (crystal defects, bonding states, etc.) can be evaluated from HAADF-STEM, PL (Photoluminescence), XPS (X-ray Photoelectron Spectroscopy), or the like. These analysis methods are examples and do not negate the specific analytical methods described in the specification.

### (FIRST EMBODIMENT)

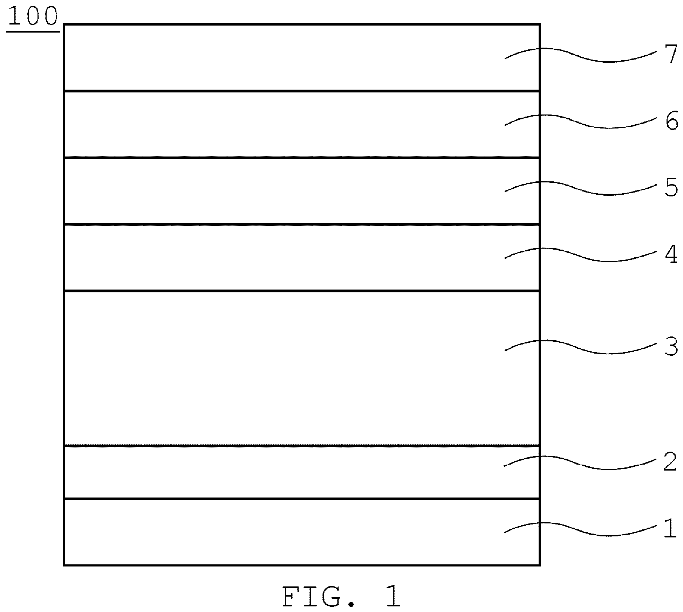

A first embodiment relates to a solar cell. A schematic cross-sectional diagram of FIG. 1 shows a solar cell 100 according to the first embodiment. The solar cell 100 shown in FIG. 1 comprises a substrate 1, a first transparent electrode 2, a p-type light-absorbing layer 3, a first n-type layer 4, a second n-type layer 5, a second transparent electrode 6, and an anti-reflection layer 7. It is preferable that the light enters from the side of the anti-reflection layer 7.

When the solar cell 100 uses transparent type electrode for the first transparent electrode 2 and the second transparent electrode 6, the solar cell 100 have high-transmittance for light having a wavelength of 700 nm or more and 1200 nm or less.

When the solar cell 100 uses transparent type electrode for the first transparent electrode 2 and the second transparent electrode 6, the solar cell 100 of the embodiment is preferably used for a top cell (light-incident side).

The substrate 1 is a transparent substrate. The substrate 1 may be made of an acrylic, polyimide, polycarbonate, polyethylene terephthalate (PET), polypropylene (PP), a fluorine based resin (e.g., polytetrafluoroethylene (PTFE), perfluoro ethylene propylene copolymer (FEP), ethylene tetrafluoroethylene copolymer (ETFE), poly chlorotrifluoroethylene (PCTFE), perfluoroalkoxy alkane (PFA)), polyarylate, polysulfone, polyether sulfone, polyether imide or other organic based substrates, or of inorganic substrates such as soda lime glass, ultra clear glass, chemically strengthened glass or quartz. The substrate 1 may be a stacked (layered) member of the above substrates.

As the substrate 1, soda lime glass, ultra clear glass, chemically strengthened glass or quartz is preferred, with soda lime glass, ultra clear glass or quartz being more preferred.

The first transparent electrode 2 is a planar conductive film. The first transparent electrode 2 is a conductive layer having light-transmittance. It is preferable that the first transparent electrode 2 includes one or more transparent conductive oxide films. As transparent conductive oxide films, semiconductor conductive films such as indium tin oxide (ITO), aluminum-doped zinc oxide (AZO), boron-doped zinc oxide (BZO), gallium-doped zinc oxide (GZO), doped tin oxide, titanium-doped indium oxide (ITiO), indium zinc oxide (IZO) or indium gallium zinc oxide (IGZO), hydrogen-doped indium oxide (IOH), etc., may be used, and the selection is not particularly limited. The transparent conductive oxide film may be a multilayer stack comprising multiple films. As dopants for tin-oxide-type films, one or more elements selected from the group consisting of In, Si, Ge, Ti, Cu, Sb, Nb, Ta, W, Mo, F, and Cl may be employed, without particular limitation. It is preferable that the first transparent electrode 2 includes a doped tin-oxide film in which one or more elements selected from the group consisting of In, Si, Ge, Ti, Cu, Sb, Nb, Ta, W, Mo, F, and Cl are doped. It is preferable that the one or more dopant elements selected from the group consisting of In, Si, Ge, Ti, Cu, Sb, Nb, Ta, W, Mo, F, and Cl be present at ten atomic percent or less relative to the tin element in the tin-oxide film. As the first transparent electrode 2, a stacked film comprising the transparent conductive oxide film and a metal film may be used. The metal included in the metal film (including alloys) is not particularly limited and may be Mo, Au, Cu, Ag, Al, Ta, W, etc. In addition, it is preferable that the first transparent electrode 2 include a dot-type, line-type or mesh-type electrode (one or more selected from the group consisting of metals, alloys, graphene, conductive nitrides and conductive oxides) positioned between the oxide transparent conductive film and the substrate 1. The dot-type, line-type or mesh-type metal should have an opening ratio of 50 % or more with respect to the transparent conductive oxide film. The dot-type, line-type or mesh-type metal may be Mo, Au, Cu, Ag, Al, Ta, W, etc., without particular limitation. When a metal film is used for the first transparent electrode 2, a film thickness of 5 nm or less is preferable from the viewpoint of transmittance. When a line-type or mesh-type metal film is used, the thickness limitation does not apply to the metal film as long as the transmittance is ensured by the openings.

Specific examples of the first transparent electrode 2 are a transparent electrode composed of an ITO film, a stacked transparent electrode of an ITO film and doped SnO₂ film; the scope is not limited to these examples.

It is preferable that the thickness of the first transparent electrode be 50 nm or more and 500 nm or less; more preferably, 50 nm or more and 300 nm or less; and even more preferably 75 nm or more and 200 nm or less.

The solar cell 100 may include an intermediate layer, for example, an insulating film of SiO₂ or MgF₂ each having a low-refractive-index, situated between the substrate 1 and the first transparent electrode 2.

The p-type light-absorbing layer 3 is, overall, a p-type semiconductor layer. The p-type light-absorbing layer 3 is provided on the first transparent electrode 2. It is preferable that the p-type light-absorbing layer 3 be in direct contact with the first transparent electrode 2. The p-type light-absorbing layer 3 is located between the first transparent electrode 2 and the first n-type layer 4. The p-type light-absorbing layer 3, which is in direct contact with the first n-type layer 4, preferably forms a pn junction with the first n-type layer 4. The p-type light-absorbing layer 3 is preferably a compound semiconductor layer. Examples of preferable materials include: a semiconductor layer including compounds having a chalcopyrite structure such as CGS or CIGS; and a semiconductor layer including compounds having a cuprite type structure such as a cuprous oxide compound. The p-type light-absorbing layer 3 is preferably mainly composed of a cuprous oxide compound. It is preferable that the cuprous oxide compound has a cuprite type structure. Hereinafter, an example using a compound including a cuprous oxide compound for the p-type light-absorbing layer 3 will be described. When other compounds are used for the p-type light-absorbing layer 3, it is preferable to adopt a configuration suitable for each compound, similar to the embodiment of the solar cell 100 described above.

It is preferable that the p-type light-absorbing layer 3 be a semiconductor layer including a cuprous oxide compound. It is preferable that the p-type light-absorbing layer 3 be a polycrystalline cuprous oxide compound. A trace amount of one or more impurities selected from the group consisting of copper (Cu), copper oxide (CuO), and copper hydroxide (Cu(OH)₂) may be included in the p-type light-absorbing layer 3 as impurities in some cases.

When the sum of all elements except oxygen element are considered to be 100 atom%, it is preferable that the copper element contained in the p-type light-absorbing layer 3 be 90 atom% or more and less than 100 atom%; more preferably 95 atom% or more and less than 100 atom%; even more preferably 98 atom% or more and less than 100 atom%; and most preferably 99 atom% or more and less than 100 atom%.

When the sum of all elements except the oxygen element are considered to be 100 atom%, it is preferable that the copper element contained in the p-type light-absorbing layer 3 be 90 atom% or more and 99.9 atom% or less; more preferably 95.0 atom% or more and 99.9 atom% or less; even more preferably 98 atom% or less and 99.9 atom% or less; and most preferably 99.0 atom% or more and 99.9 atom% or less.

The cuprous oxide compound includes copper and oxygen and optionally includes an element represented by M1. The element represented by M1 is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr, and Ca.

When the amount of copper atoms denoted as 1, it is preferable that the amount of oxygen atoms included in the cuprous oxide compound be preferably 0.48 or more and 0.56 or less. When there is a large amount of oxygen relative to copper, the ratio of copper oxide included in the cuprous oxide compound increases, resulting in a narrowed band gap and reduced transmittance of the p-type light-absorbing layer 3, which is undesirable. When the amount of oxygen is small relative to the copper ratio, the amount of copper included in the copper oxide (cupric oxide) compound increases, resulting in reduced transmittance, which is also undesirable. Moreover, when the ratio of oxygen to copper does not fall within the above range, it becomes difficult for the cuprous oxide compound to have a cuprite-type structure.

It is preferable that 95 wt% or more and less than 100 wt% of the p-type light-absorbing layer 3 be the cuprous oxide compound; more preferably 98 wt% or more and less than 100 wt% be the cuprous oxide compound; and most preferably 99 wt% or more and less than 100 wt% be the cuprous oxide compound. The p-type light-absorbing layer 3 may be composed entirely of the cuprous oxide compound.

When the p-type light-absorbing layer 3 has less heterogeneity and good crystallinity, the transmittance of the p-type light-absorbing layer 3 tends to increase, which is preferable. The band gap of the p-type light-absorbing layer 3 can be adjusted by means such as including elements other than Cu and O in the p-type light-absorbing layer 3. It is preferable that the band gap of the p-type light-absorbing layer 3 is 2.0 eV or more and 2.2 eV or less. Within this range, both the top cell and bottom cell can efficiently utilize solar light in a multi-junction solar cell where a silicon-based solar cell is used as a bottom cell and the solar cell 100 of the embodiment is used as a top cell. It is preferable that the p-type light-absorbing layer 3 contain Sn or/and Sb. The Sn or Sb in the p-type light-absorbing layer 3 may be added to the p-type light-absorbing layer 3, or it may originate from the first transparent electrode 2. The Ga contained in the p-type light-absorbing layer 3 is not included in the raw materials for forming the p-type light-absorbing layer 3, but rather diffuses from the Ga contained in the first n-type layer 4. Other elements may also diffuse into the p-type light-absorbing layer 3 when they are used during the formation of the first n-type layer 4.

The composition ratio of the above p-type light-absorbing layer 3 is the overall composition ratio of the p-type light-absorbing layer 3. The compound composition ratio of the above p-type light-absorbing layer 3 is preferably satisfied overall in the p-type light-absorbing layer 3.

It is preferable that the p-type light-absorbing layer 3 have a p+ type (p plus type) region on the first transparent electrode 2 side.

It is preferable that the p-type light-absorbing layer 3 have a p- type (p minus type) region on the first n-type layer 4 side.

It is preferable that the p-type light-absorbing layer 3 have a p- type (p minus type) region on the first n-type layer 4 side and a p+ type (p plus type) region on the first transparent electrode 2 side.

It is preferable that the thickness of the p-type light-absorbing layer 3 be 500 nm or more and 10 µm or less; and more preferably 750 nm or more and 7.0 µm or less. It is preferable that the p-type light-absorbing layer 3 be the thickest layer among the layers included between the first transparent electrode 2 and the second transparent electrode 6. The p-type light-absorbing layer 3 is preferably the thickest semiconductor layer included in the solar cell 100.

It is preferable that the surface of the p-type light-absorbing layer 3 on the first n-type layer 4 side has fine unevenness. It is preferable that the average deviation of the surface roughness of the p-type light-absorbing layer 3 on the first n-type layer 4 side be 50 nm or more; more preferably 50 nm or more and 500 nm or less; and even more preferably 55 nm or more and 300 nm or less.

It is preferable that the p-type light-absorbing layer 3 be formed by a sputtering method, for example. More specifically, a member on which the first transparent electrode 2 is formed on the substrate 1 is heated to 300 °C or more and 1000 °C or less, and deposition is performed in an oxygen partial pressure of 0.01 Pa or more and 4.8 Pa or less at a rate of 0.02 µm/min or more and 20 µm/min or less. In view of forming a transparent polycrystalline film with a large grain size, it is more preferable that the oxygen partial pressure satisfy 0.20×d (0.20 times d) Pa or more and 1.00×d (1.00 times d) Pa or less (for example, in the case of high-temperature sputtering, 0.20 × d Pa or more and 0.50×d Pa or less is preferable, and in the case of low-temperature sputtering, 0.55×d Pa or more and 1.00×d Pa or less is preferable) where d represents the deposition rate. Furthermore, a heating temperature of 550 °C or higher and 850 °C or lower is more preferable. The element M1 can be added during film formation.

By forming the p-type light-absorbing layer 3 by the method described above, a large-grained cuprous oxide compound is formed. It is preferable that the p-type light-absorbing layer 3 include crystals of the cuprous oxide compound having a grain size that is five times or more the thickness of the p-type light-absorbing layer 3.

The first n-type layer 4 is an n-type semiconductor layer that transmits visible light. The first n-type layer 4 is located between the p-type light-absorbing layer 3 and the second n-type layer 5. The first n-type layer 4 is preferably provided on the p-type light-absorbing layer 3. For example, the first n-type layer 4 may be formed by an ALD method. The first n-type layer 4 is preferably mainly amorphous, but may include some crystals.

The first n-type layer 4 is preferably not a metal oxide layer mainly including titanium. The first n-type layer 4 is preferably a compound (oxide) mainly including Ga. The first n-type layer 4 is preferably a compound (oxide) mainly including Ga and Zn.

The thickness of the first n-type layer 4 is typically 3 nm or more and 100 nm or less. When the thickness of the first n-type layer 4 is less than 3 nm, a leakage current may occur when the coverage of the first n-type layer 4 is poor, which may deteriorate the characteristics. The thickness is not limited to the above if the coverage is good. When the thickness of the first n-type layer 4 exceeds 50 nm, the characteristics may deteriorate due to excessive high resistance of the first n-type layer 4, and a short circuit current may decrease due to reduced transmittance. Therefore, it is more preferable that the thickness of the first n-type layer 4 be 3 nm or more and 20 nm or less, and even more preferably 5 nm or more and 20 nm or less.

It is preferable that the titanium content among the metal elements included in the first n-type layer 4 be 0 atom% or more and 10 atom% or less; more preferably 0 atom% or more and 5 atom% or less; and even more preferably 0 atom% or more and 1 atom% or less.

The first n-type layer 4 may be a single layer or a multilayer. It is preferable that the first n-type layer 4 include a first layer including an oxide including Ga as a main component and a second layer optionally including Zn oxide as the main component. The first layer is preferably located on the p-type light-absorbing layer 3 side, and the second layer is preferably located on the second n-type layer 5 side. It is preferable that the first layer be in direct contact with the p-type light-absorbing layer 3 and the second layer be in direct contact with the second n-type layer 5. An intermediate layer may exist between the first layer and the second layer. The interface may not exist between the first layer and the second layer, and the composition may slope gradually.

It is preferable that the lower edge of the conduction band be continuous from the p-type light-absorbing layer 3 to the second layer of the first n-type layer 4.

The oxide including Ga as a main component preferably includes Ga₂O₃ or an oxide including Ga and an element represented by M2. For example, the Ga oxide preferably has an average composition represented by Gaₕ₁M2ᵢ₁Oⱼ₁. It is preferable that h1, i1, and j1 satisfy 1.8 ≤ h1 ≤ 2.1, 0.0 ≤ i1 ≤ 0.2, and 2.9 ≤ j1 ≤ 3.1, respectively. It is preferable that the element M2 be one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr, and Nd. It is preferable that the first layer includes 90 wt% or more and 100 wt% or less of the oxide represented by the average composition Gaₕ₁M2ᵢ₁Oⱼ₁.

The compound (oxide) including Zn as a main component is preferably zinc oxide doped with one or more elements selected from the group consisting of Sn, Sb, Hf, Zr, Si, Al, and Mg. It is preferable that the compound including Zn as a main component for the second layer be Sn doped Zn oxide. It is preferable that 90 wt% or more and 100 wt% or less of the second layer be the compound including Zn as a main component.

To increase the transmittance between the first layer and the second layer, it is preferable that the refractive index difference between the first layer and the second layer be small. It is preferable that the refractive index difference be 0.1 or less; more preferably 0.05 or less; and even more preferably 0.03 or less. The thickness and refractive index of each layer included in the solar cell 100 can be determined by a spectroscopic ellipsometry method, for example. The refractive indices described in this specification are all values measured at a wavelength of 700 nm.

The second n-type layer 5 is an n-type semiconductor layer that transmits visible light. The second n-type layer 5 is located between the first n-type layer 4 and the second transparent electrode 6. For example, the second n-type layer 5 can be formed by an ALD method. The second n-type layer 5 is preferably mainly amorphous, but may contain some crystals. By including the second n-type layer 5 in addition to the first n-type layer 4, it is preferable to increase the light transmittance of the solar cell 100 in a wavelength band of 600 nm or more and 1100 nm or less.

It is preferable that the thickness of the second n-type layer 5 be 1 nm or more and 50 nm or less; more preferably 5 nm or more and 30 nm or less; and even more preferably 10 nm or more and 30 nm or less. When the thickness of the second n-type layer 5 is 100 nm or more, the transmittance and short-circuit current density of the solar cell 100 may decrease. Therefore, it is preferable that the thickness of the second n-type layer 5 be 50 nm or less.

It is preferable that the second n-type layer 5 include a titanium-including metal oxide. It is more preferable that the second n-type layer 5 be mainly composed of a titanium-including metal oxide. It is preferable that the content of the titanium-including metal oxide in the second n-type layer 5 is 50 wt% or more and 100 wt% or less; more preferably 80 wt% or more and 100 wt% or less; and even more preferably 95 wt% or more and 100 wt% or less.

It is preferable that the titanium content among the metal elements included in the second n-type layer 5 be 45 atom% or more and 100 atom% or less; and more preferably 80 atom% or more and 100 atom% or less. It is preferable that the titanium content among the metal elements included in the first n-type layer 4 be 0 % or more and 10 % or less of the titanium content in the second n-type layer 5; more preferably 0 % or more and 5 % or less; and even more preferably 0 % or more and 1 % or less.

Since the absorption band wavelength of the titanium-including metal oxide is mainly 400 nm or less, which is shorter than the absorption band wavelength of the p-type light-absorbing layer 3, which is the photovoltaic power generation layer of the solar cell 100, and shorter than the absorption band wavelength of a Si solar cell, even when the second n-type layer 5 is provided on the light incidence side of the p-type light-absorbing layer 3, the conversion efficiency can be increased.

The titanium-including metal oxide included in the second n-type layer 5 is preferably one or more selected from the group consisting of titanium dioxide, doped titanium dioxide, and doped strontium titanate. It is preferable that the dopant of the doped titanium dioxide and the doped strontium titanate be one or more selected from the group consisting of Nb, Ta, Mo, and W; and more preferably Nb. For titanium dioxide, the anatase type is preferable. For strontium titanate, the cubic perovskite type is preferable.

The second n-type layer 5 may be a single layer or multiple layers. The multilayer second n-type layer 5, for example, includes a TiO₂ layer on the side of the first n-type layer 4 and a strontium titanate layer having a higher refractive index than that of the TiO₂ layer on the side of the second transparent electrode 6.

When the surface of the p-type light-absorbing layer 3 has fine unevenness, it is preferable that the second n-type layer 5 also have fine unevenness on its surface facing the second transparent electrode 6 due to the surface unevenness of the p-type light-absorbing layer 3. It is preferable that the average deviation of surface roughness on the side of the second transparent electrode 6 of the second n-type layer 5 be 50 nm or more; more preferably 50 nm or more and 500 nm or less; and even more preferably 55 nm or more and 300 nm or less. The fine unevenness of the second n-type layer 5 caused by the increase in grain size of the p-type light-absorbing layer 3 can reduce light reflection by acting similarly to the anti-reflection layer 7. It is preferable that the surface also have similar fine unevenness.

From the viewpoint of reducing reflection between the second n-type layer 5 and the second transparent electrode 6, it is preferable that the second n-type layer 5 be in direct contact with the second transparent electrode 6.

From the viewpoint of reducing reflection between the first n-type layer 4 and the second transparent electrode 6, it is preferable that the second n-type layer 5 be in direct contact with the first n-type layer 4.

It is preferable that the conduction band lower edge be continuous from the p-type light-absorbing layer 3 to the second n-type layer 5.

The second transparent electrode 6 is disposed between the second n-type layer 5 and the anti-reflection layer 7. The second transparent electrode 6 is an electrode on the side of the second n-type layer 5, which has light transmittance in visible light. It is preferable that the second transparent electrode 6 be provided on the second n-type layer 5. It is preferable that the second transparent electrode 6 use a transparent conductive oxide film. It is preferable that the transparent conductive oxide film used in the second transparent electrode 6 be one or more semiconductor conductive films selected from the group consisting of indium tin oxide, aluminum-doped zinc oxide, boron-doped zinc oxide, gallium-doped zinc oxide, indium-doped zinc oxide, titanium-doped indium oxide, indium gallium zinc oxide, and hydrogen-doped indium oxide. The dopant for the film such as tin oxide is not particularly limited as long as it is one or more selected from the group consisting of In, Si, Ge, Ti, Cu, Sb, Nb, Ta, W, Mo, F, and Cl. The second transparent electrode 6 may include a mesh or line-shaped electrode to reduce the resistance of the transparent conductive oxide film. The mesh or line-shaped electrodes are not particularly limited and may be Mo, Au, Cu, Ag, Al, Ta, or W. Graphene can also be used for the second transparent electrode 6. Preferably, the graphene is laminated with silver nanowires.

The thickness of the second transparent electrode 6 can be determined by cross-sectional observation using an electron microscope or by a step meter.

It is preferable that the thickness of the second transparent electrode 6 be 30 nm or more and 2 µm or less; more preferably 30 nm or more and 100 nm or less; and even more preferably 30 nm or more and 70 nm or less.

It is preferable that the refractive index of the second transparent electrode 6 be 1.6 or more and 1.99 or less; more preferably 1.6 or more and 1.9 or less; and even more preferably 1.6 or more and 1.85 or less.

It is preferable that the second transparent electrode 6 be formed by a method such as ALD or sputtering.

The anti-reflection layer 7 has light transmittance in visible light. The anti-reflection layer 7 is provided on the second transparent electrode 6. The anti-reflection layer 7 may be in direct contact with the second transparent electrode 6, or another layer may be sandwiched between the anti-reflection layer 7 and the second transparent electrode 6. From the viewpoint of increasing the amount of light incident on the p-type light-absorbing layer 3, which is the photovoltaic power generation layer of the solar cell 100, it is preferable to provide the anti-reflection layer 7. Moreover, by increasing the transmittance of light other than the absorption band wavelength of the p-type light-absorbing layer 3, when a solar cell as a bottom cell for a multi-junction solar cell having the solar cell 100 as a top cell and the bottom cell has a narrow bandgap light absorbing layer such as a Si solar cell, it contributes to increase the power generation amount of the bottom cell.

The anti-reflection layer 7 includes one or more inorganic materials and/or organic materials selected from the group consisting of SiO₂, MgF₂, MgO, Al₂O₃, etc. It is preferable that the layers from the substrate 1 to the second transparent electrode 6 be dense layers that are not porous. However, the anti-reflection layer 7 may be a dense layer or a porous layer. The antireflection layer 7 may have regular or irregular protrusions.

The thickness of the anti-reflection layer 7 is not particularly limited but is typically 70 nm or more and 130 nm or less.

It is preferable that the refractive index (including the apparent refractive index of a porous anti-reflection layer 7 or an anti-reflection layer 7 having protrusions) of the anti-reflection layer 7 be 1.3 or more and 1.7 or less; more preferably 1.3 or more and 1.5 or less; and even more preferably 1.3 or more and 1.47 or less.

Next, the refractive indices of the second n-type layer 5, the first n-type layer 4 (if necessary), and the second transparent electrode 6 will be described. The refractive index of the second n-type layer 5 is preferably higher than that of the first n-type layer 4. Although the refractive indices of the second transparent electrode 6 and the first n-type layer 4 are close, using a second n-type layer 5 having a higher refractive index than that of the first n-type layer 4 suppresses reflection of light between the first n-type layer 4 and the second transparent electrode 6, thereby improving transmittance.

From the above viewpoint, it is preferable that the refractive index of the second n-type layer 5 be 2.0 or more and 2.5 or less; more preferably 2.1 or more and 2.5 or less; and even more preferably 2.2 or more and 2.4 or less.

From the above viewpoint, it is preferable that the refractive index (maximum value and average value) of the first n-type layer 4 be 1.6 or more and 1.99 or less; more preferably 1.6 or more and 1.9 or less; and even more preferably 1.6 or more and 1.85 or less.

From the above viewpoint, it is preferable that the refractive index on the second n-type layer 5 side of the first n-type layer 4 (refractive index of the second layer) be 1.6 or more and 1.99 or less; more preferably 1.6 or more and 1.9 or less; and even more preferably 1.6 or more and 1.85 or less.

From the above viewpoint, it is preferable that the refractive index of the second n-type layer 5 be 0.01 or more and 0.9 or less higher than the refractive index (maximum value and average value) of the first n-type layer 4; more preferably 0.2 or more and 0.9 or less higher; and even more preferably 0.35 or more and 0.8 or less higher.

From the above viewpoint, it is preferable that the refractive index of the second n-type layer 5 be 0.01 or more and 0.9 or less higher than the refractive index on the second n-type layer 5 side of the first n-type layer 4 (refractive index of the second layer); more preferably 0.2 or more and 0.9 or less higher; and even more preferably 0.35 or more and 0.8 or less higher.

From the viewpoint of improving light transmittance, it is preferable that the refractive indices between the first n-type layer 4 and the second transparent electrode 6 follow a moderate-high-moderate profile. In other words, it is preferable that the refractive index of the second n-type layer 5 be higher than the refractive index of the second transparent electrode 6.

From the viewpoint of improving light transmittance, it is preferable that the refractive indices between the first n-type layer 4 and the anti-reflection layer 7 follow a moderate-high-moderate-low profile. In other words, it is preferable the refractive index of the second n-type layer 5 be higher than the refractive index of the second transparent electrode 6, and the refractive index of the anti-reflection layer 7 be lower than the refractive indices of the first n-type layer 4, the second n-type layer 5, and the second transparent electrode 6.

From the above viewpoint, it is preferable that the refractive index of the second transparent electrode 6 be 1.6 or more and 1.99 or less; more preferably 1.6 or more and 1.9 or less; and even more preferably 1.6 or more and 1.85 or less.

From the above viewpoint, it is preferable that the refractive index of the second n-type layer 5 be 0.01 or more and 0.9 or less higher than the refractive index of the second transparent electrode 6; more preferably 0.2 or more and 0.9 or less higher; and even more preferably 0.35 or more and 0.8 or less higher.

Moreover, from the viewpoint of improving light transmittance, it is preferable that the refractive index and thickness of the second n-type layer 5 satisfy the following relationship. When the refractive index of the second n-type layer 5 is denoted as n1 and the thickness of the second n-type layer 5 is denoted as d1, it is preferable that n1 and d1 nm satisfy 2 nm ≤ n1×d1 nm ≤ 125 nm; more preferably 2 nm ≤ n1×d1 nm ≤ 115 nm; even more preferably 20 nm ≤ n1×d1 nm ≤ 100 nm; and even more preferably 20 nm ≤ n1×d1 nm ≤ 70 nm.

From the viewpoint of improving the conversion efficiency of the solar cell 100, it is preferable that the carrier concentration of the second n-type layer 5 and the carrier concentration of the first n-type layer 4 be high. Therefore, it is preferable to use the above-described first n-type layer 4 and the second n-type layer 5 as the n-type layers of the solar cell 100.

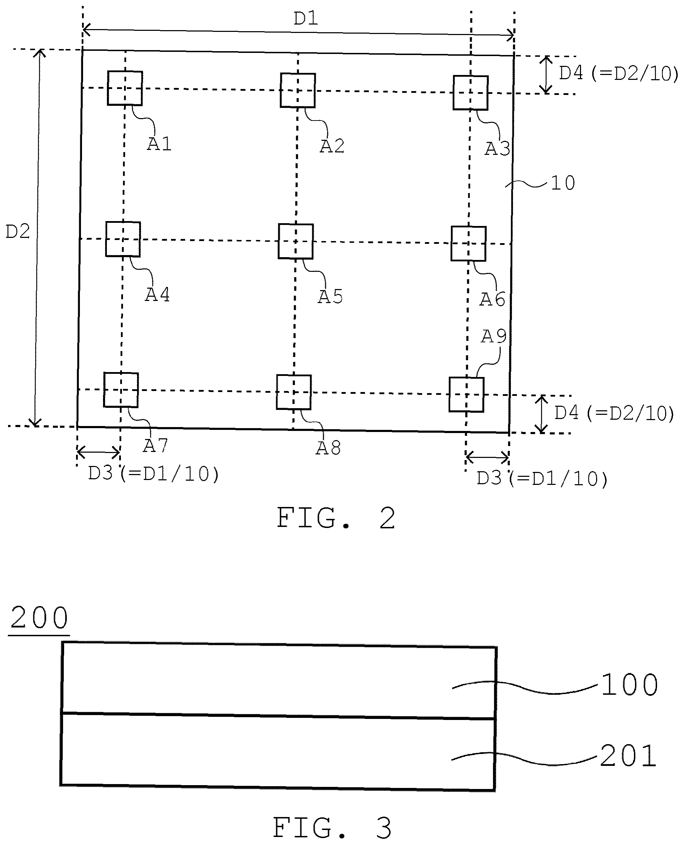

The compositional analysis of a layer such as the second n-type layer 5 can be determined by analyzing, for example, with TEM-EDX (Transmission Electron Microscopy-Energy Dispersive X-ray Spectroscopy) analysis spots (A1 to A9) distributed as evenly spaced as possible, as shown in the diagram of FIG. 2 which explains the analysis spots. FIG. 2 is a schematic diagram showing solar cell 100 viewed from the side of the second transparent electrode 6. D1 is the length of the solar cell 100 in the width direction (long side), and D2 is the length of the solar cell 100 in the depth direction (short side). TEM with a magnification of 2 million times, analyzing a 100 nm × 100 nm area including the center of each analysis spot. The chemical bonding state can be evaluated by XPS analysis of the center of each analysis spot in the thickness direction of the solar cell 100, allowing identification of the compounds present in each layer. Furthermore, SEM can be used to observe the surface irregularities and grain sizes of each layer.

### (SECOND EMBODIMENT)

A second embodiment relates to a multi-junction solar cell. FIG. 3 shows a schematic cross-sectional diagram of the multi-junction solar cell 200 according to this embodiment. The multi-junction solar cell 200 in FIG. 3 includes a first solar cell 100 according to the first embodiment on the light incident side and a second solar cell 201. The light-absorbing layer of the second solar cell 201 has a smaller bandgap than that of the p-type light absorbing layer 3 of the first solar cell 100 according to the first embodiment. Note that the multi-junction solar cell 200 according to this embodiment also includes a solar cell having three or more solar cells joined together.

Since the bandgap of the p-type light-absorbing layer (cuprous oxide) 3 of the first solar cell 100 according to the second embodiment is about 2.0 eV or more and 2.2 eV or less, the bandgap of the light-absorbing layer of the second solar cell 201 is preferably 1.0 eV or more and 1.6 eV or less. The light-absorbing layer of the second solar cell 201 may be one or more compound semiconductor layers selected from the group consisting of CIGS-based compounds and CdTe-based compounds with a high In content, crystalline silicon, and perovskite-type compounds.

### (THIRD EMBODIMENT)

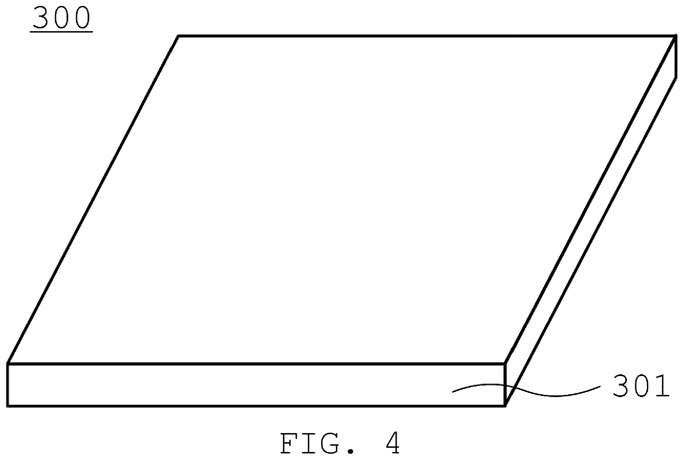

A third embodiment relates to a solar cell module. FIG. 4 shows a perspective schematic diagram of the solar cell module 300 according to the embodiment. The solar cell module 300 includes a first solar cell module 301 including a plurality of the solar cells 100 or a first solar cell module 301 including a plurality of the multi-junction solar cells 200. The solar cell module 300 can be installed on the light incident side of an existing solar cell module.

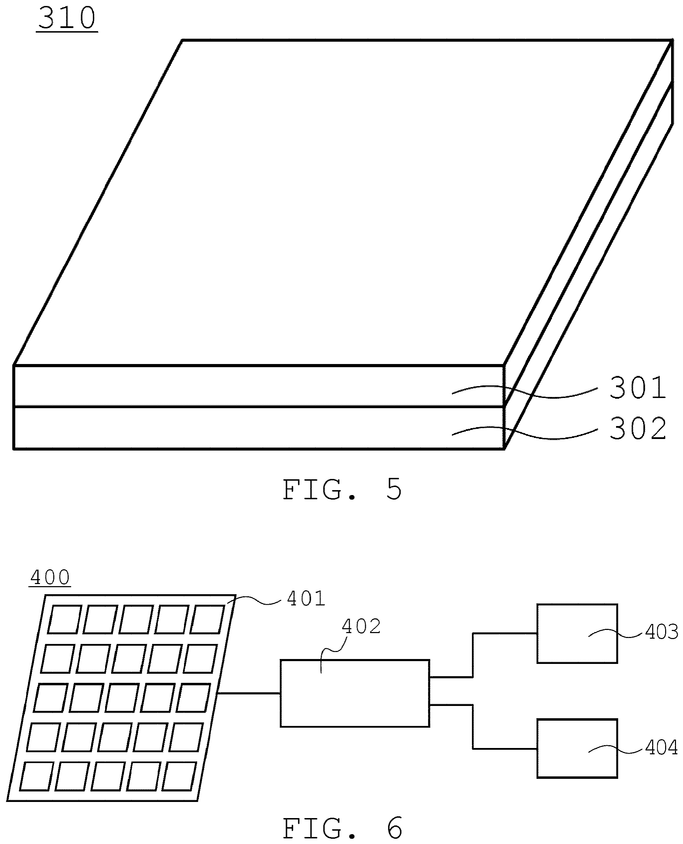

FIG. 5 shows a schematic perspective diagram of the solar cell module 310 according to the embodiment. The solar cell module 310 is a multi-junction solar cell module (tandem solar cell module) comprising a stacked first solar cell module 301 including a plurality of solar cells 100 and a second solar cell module 302. The first solar cell module 301 is located on the light incident side. The second solar cell module 302 preferably uses the second solar cell 201.

### (FOURTH EMBODIMENT)

A fourth embodiment relates to a photovoltaic power generation system. In the photovoltaic power generation system according to the embodiment, the solar cell modules of the embodiments can be used as generators for power generation. The photovoltaic power generation system specifically includes: the solar cell modules that generate electricity using solar cells; a converting element (converter) converting generated electricity into electrical power; and a storing element (battery) storing the generated electricity (battery) or a load element (load) consuming the generated electricity. FIG. 6 shows a configurational diagram of the photovoltaic power generation system 400 according to the embodiment. The photovoltaic power generation system in FIG. 6 includes a solar cell module 401 (300), a converter 402, a battery 403, and a load 404. Either the battery 403 or the load 404 may be omitted. The load 404 can also be configured to utilize the electrical energy stored in the battery 403. The converter 402 is a device that includes circuits or elements for power conversion such as voltage transformation and DC-AC conversion, such as a DC-DC converter, a DC-AC converter, an AC-AC converter. The configuration of the converter 402 should be appropriately selected according to the generation voltage, the configuration of the battery 403 and the load 404.

The solar cell module 401 receives sunlight and generates electricity, which is then converted by the converter 402 and stored in the battery 403 or consumed by the load 404. The solar cell module 401 may be equipped with a sun-tracking drive mechanism for always directing the solar cell module toward the sun, or a concentrator for collecting sunlight to improve power generation efficiency. As the load 404, an electrolyzer that performs water electrolysis, CO₂ electrolysis, ammonia electrolysis, ammonia synthesis, or other similar processes can be used.

The photovoltaic power generation system 400 is preferably used in real estate such as residences, commercial facilities, and factories, or in movable property such as vehicles, aircraft, and electronic equipment. By using highly efficient solar cells according to the embodiment in the solar cell modules, an increase in the amount of power generated can be expected.

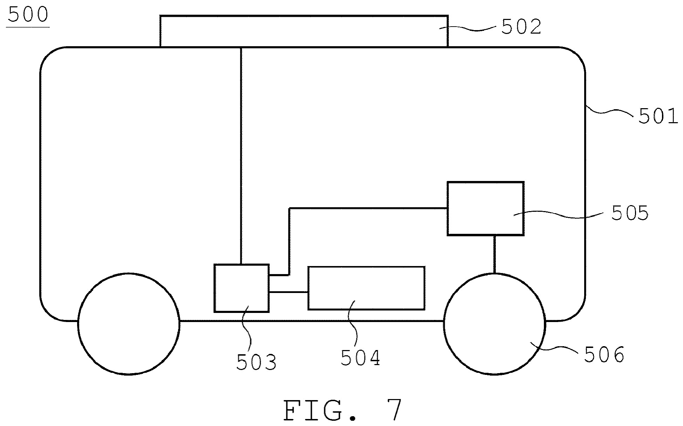

As an example of the use of the photovoltaic power generation system 400, a vehicle is shown. FIG. 7 shows a schematic diagram of the configuration of the vehicle 500 according to the embodiment. The vehicle 500 includes a vehicle body 501, a solar cell module 502, a power conversion device 503, a battery 504, a motor 505, and tires (wheels) 506. Electricity generated by the solar cell module 502 mounted on the top of the vehicle body 501 is converted by the power conversion device 503 and charged to the battery 504 or consumed by loads such as the motor 505. The vehicle 500 can be driven by rotating the tires (wheels) 506 with a motor 505 using electricity supplied from the solar cell module 502 or the battery 504. The solar cell module 502 may consist solely of a first solar cell module equipped with the solar cells according to the first embodiment, such as the solar cell 100, instead of a tandem type. When a transparent solar cell module 502 is adopted, it is preferable to use the solar cell module 502 as a window that generates electricity on the side of the vehicle body 501 in addition to the top of the vehicle body 501.

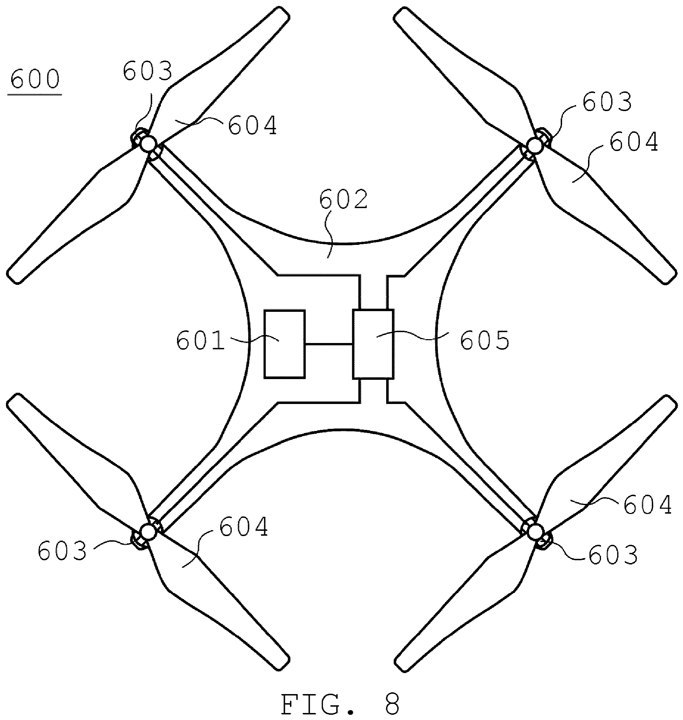

As an example of using the photovoltaic power generation system 400, a drone (quadcopter) is shown. The drone uses the solar cell module 401. The configuration of the drone 600 according to the embodiment will be briefly explained with reference to a schematic diagram of FIG. 8. The drone 600 includes a solar cell module 601, a frame body 602, motors 603, rotors 604, and a control unit 605. The solar cell module 601, motors 603, rotors 604, and control unit 605 are located on the frame body 602. The control unit 605 converts or adjusts the output power from the solar cell module 601. The motor 603 rotates the rotor 604 using the power output from the solar cell module 601. By providing a drone 600 of this configuration with the solar cell module 601 according to this embodiment, a drone that can fly using more power can be provided.

The present invention will be described in more detail below based on examples; however, the present invention is not limited to the following examples.

### (Example A1)

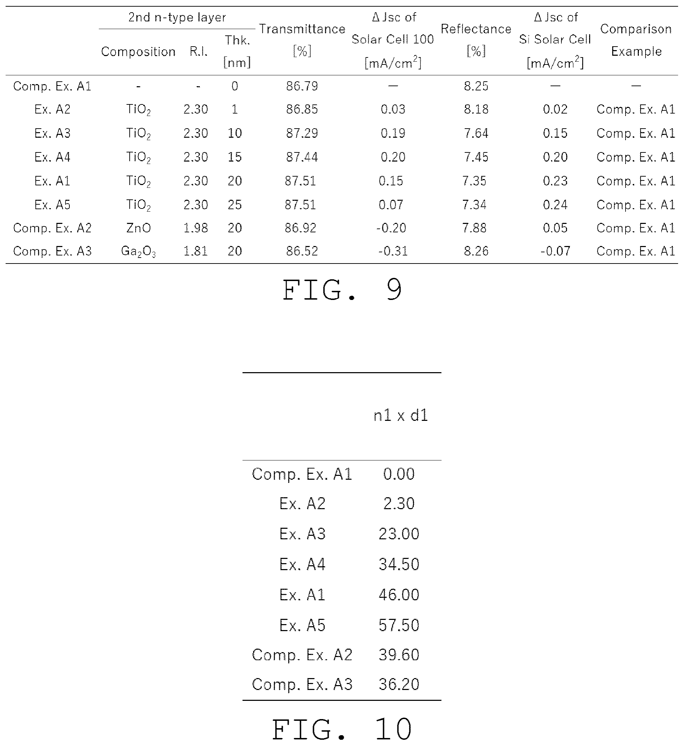

Simulations were performed under the following conditions. Since the simulation was an evaluation of transmittance using a second n-type layer 5 rather than power generation characteristics, the calculations were performed for part of the configuration of the solar cell 100 that did not generate electricity. In the simulation, a structure in which a substrate 1, the first transparent electrode 2, the p-type light-absorbing layer 3, the first n-type layer 4, the second n-type layer 5, the second transparent electrode 6, and an anti-reflection layer 7 were sequentially stacked. By simulation, the transmittance and reflectance of light in a wavelength band from 600 nm to 1000 nm were calculated. Example A1 was simulated under the following conditions (see next paragraph). Simulation conditions and transmittance and reflectance of light in a wavelength band of 600 nm to 1000 nm are shown in Table of FIG. 9. In addition, ΔJsc (mA/cm²), which is the change in short-circuit current density of the solar cell 100 calculated from the variation in absorption rate in the p-type light-absorbing layer 3, is also shown in Table of FIG. 9. Furthermore, ΔJsc (mA/cm²), which is the change in short-circuit current density of a Si solar cell that generates electricity with light transmitted through the simulated member, is also shown in Table of FIG. 9.

### The substrate 1: Ultra clear glass (thickness 0.5 mm, refractive index 1.53)

The first transparent electrode 2: ITO (In:Sn = 80:20, film thickness 100 nm, refractive index 1.89) on the substrate 1 side and ATO (Sn:Sb = 98:2, film thickness 50 nm, refractive index 1.95) on the p-type light-absorbing layer 3 side
The p-type light-absorbing layer 3: Cu₂O layer (thickness 6.0 µm, refractive index 2.87);
The first n-type layer 4: Ga₂O₃ (film thickness 10 nm, refractive index 1.81) on the p-type light-absorbing layer 3 side (first layer), and ZnSnO (Zn:Sn = 80:20) (film thickness 14 nm, refractive index 1.83) on the second n-type layer 5 side;
The second n-type layer 5: Anatase TiO₂ layer (film thickness 20 nm, refractive index 2.30);
The second transparent electrode 6: AZO (Zn:Al = 19:1, film thickness 40 nm, refractive index 1.78); and
Anti-reflection layer: MgF2 (film thickness 90 nm, refractive index 1.38).

Simulation method: The transmittance and reflectance of the solar cell were simulated using e-ARC (a thin-film solar cell characteristic simulation software from the National Institute of Advanced Industrial Science and Technology). The ΔJsc, i.e., change in short-circuit current density of a Si solar cell was estimated based on the change in transmittance compared to the reference value.

### (Examples A1 to A5 (Ex. A1 to Ex. A5), Comparative Examples A1 to A3 (Comp. Ex.1 to Comp. Ex. A3))

Simulations were performed by changing the thickness of the second n-type layer 5 as shown in Table of FIG. 9. Table of FIG. 9 shows the simulation conditions and the transmittance, reflectance of the solar cell 100, the change in short-circuit current density of the solar cell 100, and the change in short-circuit current density of a Si solar cell. The relationship between the refractive index and thickness of the second n-type layer 5 is shown in Table of FIG. 9. The value of n1 (refractive index of the second n-type layer 5) x d1 (thickness of the second n-type layer 5) is shown in Table of FIG. 10. The ΔJsc of Example A1 was a change in Jsc with respect to the reference value of Comparative Example A1, which was used as a comparison for Example A1. The ΔJsc of the Si solar cell in Example A1 was a change in Jsc with respect to the reference value of Comparative Example A1, which was used as a comparison example for Example A1.

### (Reference Example A1)

An Ultra clear glass substrate 1 is used as the substrate 1, and ITO (In:Sn = 80:20, film thickness 150 nm) and ATO (Sn:Sb = 98:2, film thickness 100 nm) are deposited on the glass side. The substrate 1 has a thickness of 0.5 mm. By sputtering method in an oxygen and argon gas atmosphere, a Cu₂O layer with a thickness of 6 µm is formed as the p-type light-absorbing layer 3 on the ATO. After forming the p-type light-absorbing layer 3, a Ga₂O₃ film with a thickness of 10 nm is formed as the first layer of the first n-type layer 4. A ZnSnO (Zn:Sn = 80:20) film with a thickness of 14 nm is formed on the Ga₂O₃ as the second layer of the first n-type layer 4. Then, AZO (ZnO:Al) with a thickness of 40 nm is formed as the second transparent electrode 6, and an MgF₂ layer with a thickness of 90 nm is formed as the anti-reflection layer 7 to obtain the solar cell 100. The solar cell in Example A1 has a structure where the second n-type layer 5 is formed in the configuration of Reference Example A1.

A solar-simulator that emulates an AM 1.5 G light source was used; under this illumination the reference Si cell was adjusted to one-sun intensity. The measurement was conducted at atmospheric pressure with a room temperature of 25 °C. The voltage is swept and the short-circuit current density Jsc (current divided by cell area) is measured. When the horizontal axis is plotted as voltage and the vertical axis as current density, the point intersecting the horizontal axis becomes the open circuit voltage Voc. On the measurement curve, when the voltage and short-circuit current density are multiplied and maximized, the points become Vmpp and Jmpp (maximum power point), respectively. Then, FF = (Vmpp * Jmpp) / (Voc * Jsc) is used to calculate the fill factor. Also, Eff = Voc * Jsc * FF is used to calculate the conversion efficiency. The transmittance of light in a wavelength band of 600 nm or more and 1000 nm or less can be measured for Reference Example A1. The second n-type layer 5 between the first n-type layer 4 and the second transparent electrode 6 allows power generation even when formed. Suitable refractive index and thickness were investigated from simulations for the second n-type layer 5 in the following examples.

From Examples A to B, by providing a TiO₂ layer as the second n-type layer 5 between the first n-type layer 4 and the second transparent electrode 6, the transmittance of the solar cell 100, the ΔJsc of the solar cell 100, and the ΔJsc of the Si solar cell were improved, and the reflectance was reduced. Although using ZnO layers or Ga₂O₃ layers that function as n-type layers for the second n-type layer 5 may improve transmittance and reduce reflectance, the ΔJsc of the solar cell 100 is reduced. Therefore, it is preferable to use a suitable n-type layer such as TiO₂ for the second n-type layer 5. When the TiO₂ layer is too thick, the ΔJsc of the solar cell 100 and the ΔJsc of the Si solar cell may decrease, so the thickness of the second n-type layer 5 is preferably 50 nm or less.

### (Example B, Examples B1 to B3 (Ex. B1 to Ex. B3), Comparative Example B1 (Comp. Ex. B1))

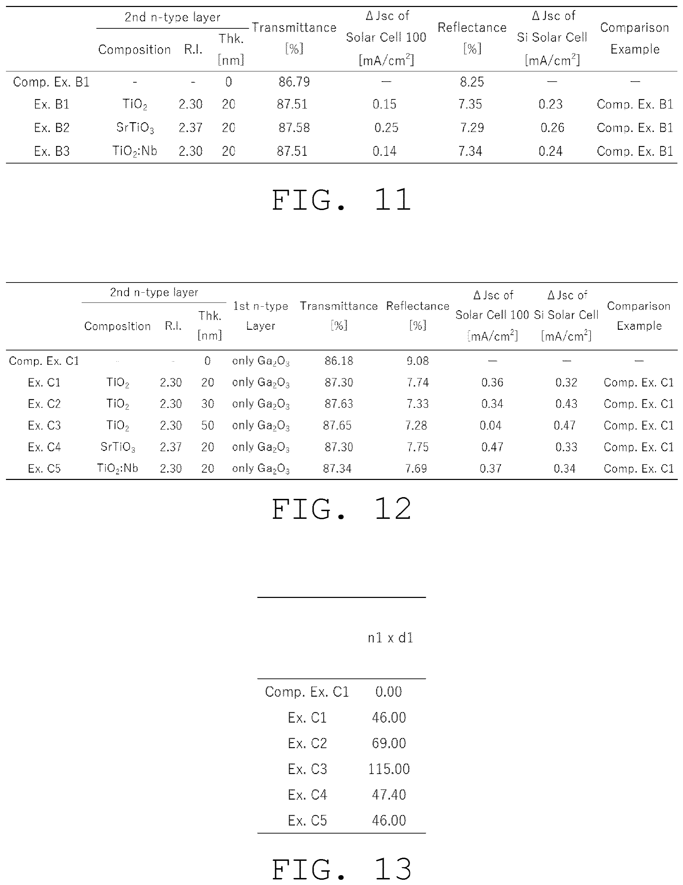

In Example B, TiO₂, SrTiO₃, and Nb-doped TiO₂ were used as the second n-type layer 5, and simulations were performed similar to those in Example A. Table of FIG. 11 shows the simulation conditions and results.

From Example B, it was confirmed that the solar cells 100 using SrTiO₃ and Nb-doped TiO₂ for the second n-type layer 5 had a similar effect to the solar cell 100 using TiO₂ for the second n-type layer 5.

### (Example C, Examples C1 to C5 (Ex. C1 to Ex. C5), Comparative Example C5 (Comp. Ex. C5))

In Example C, simulations were conducted for solar cells where only Ga₂O₃ was used for the first n-type layer 4 and the second n-type layer 5 was in contact with Ga₂O₃. Table of FIG. 12 shows the simulation conditions and results. Table of FIG. 13 shows the values of n1 (refractive index of the second n-type layer 5) × d1 (thickness of the second n-type layer 5).

From Example C, it was confirmed that a similar effect could be obtained even when the configuration of the first n-type layer 4 was different from that in Example A.

### (Example D, Examples D1 to D4 (Ex. D1 to Ex. D4), Comparative Examples D1 to D2 (Comp. Ex. D1 to Comp. Ex. D2))

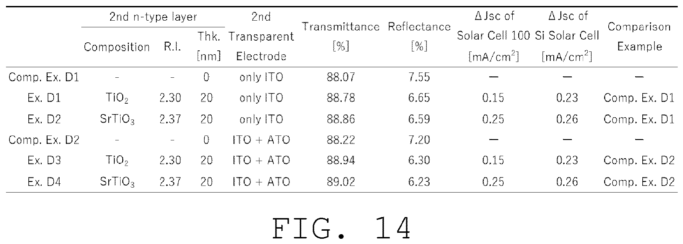

In Example D, simulations were performed for solar cells with a configuration where the second transparent electrode 6 was a single-layer oxide transparent conductive film and another configuration where it was a two-layer oxide transparent conductive film. Table of FIG. 14 shows the simulation conditions and results. The ITO of the second transparent electrode 6 in Examples D3 to D4 and Comparative Examples D2 is located on the side of the second n-type layer 5.

From Example D, it was confirmed that a similar effect could be obtained even when the configuration of the second transparent electrode 6 was different from that in Example A.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Some elements are expressed only by element symbols thereof.

### [List of embodiments]

### Embodiment 1.

A solar cell (100) comprising:
a first transparent electrode (2);
a p-type light absorbing layer (3) provided on the first transparent electrode (2);
a first n-type layer (4) provided on the p-type light absorbing layer (3);
a second n-type layer (5) provided on the first n-type layer (4);
a second transparent electrode (6) provided on the second n-type layer (5); and
an anti-reflection layer (7) provided on the second transparent electrode (6), wherein
the refractive index of the second n-type layer (5) is higher than the refractive index of the first n-type layer (4), and
the second n-type layer (5) comprises a titanium-including metal oxide.

### Embodiment 2.

The solar cell (100) according to Embodiment 1, wherein
content of the titanium-including metal oxide in the second n-type layer (5) is 50 wt% or more and 100 wt% or less

### Embodiment 3.

The solar cell (100) according to Embodiment 1 or 2, wherein
the titanium-including metal oxide included in the second n-type layer (5) is one or more selected from the group consisting of titanium dioxide, doped titanium dioxide, and doped strontium titanate.

### Embodiment 4.

The solar cell (100) according to any one of Embodiments 1 to 3, wherein
the titanium-including metal oxide included in the second n-type layer (5) is one or more selected from the group consisting of titanium dioxide, doped titanium dioxide, and doped strontium titanate, and
dopant of the doped titanium dioxide and doped strontium titanate is one or more selected from the group consisting of Nb, Ta, Mo, and W.

### v 5.

The solar cell (100) according to any one of Embodiments 1 to 4, wherein
titanium content among the metal elements included in the first n-type layer (4) is 0 atom% or more and 10 atom% or less, and
titanium content among the metal elements included in the second n-type layer (5) is 45 atom% or more and 100 atom% or less.

### Embodiment 6.

The solar cell (100) according to any one of Embodiments 1 to 5, wherein
a thickness of the second n-type layer (5) is 1 nm or more and 50 nm or less.

### Embodiment 7.

The solar cell (100) according to any one of Embodiments 1 to 6, wherein
the refractive index of the second n-type layer (5) is higher than the refractive index of the second transparent electrode (6).

### Embodiment 8.

The solar cell (100) according to any one of Embodiments 1 to 7, wherein
the refractive index of the second n-type layer (5) is denoted as n1,
a thickness of the second n-type layer (5) is denoted as d1, and
n1 and d1 nm satisfy 2 nm ≤ n1×d1 nm ≤ 125 nm.

### Embodiment 9.

The solar cell (100) according to any one of Embodiments 1 to 8, wherein
the refractive index of the second n-type layer (5) is 0.01 or more and 0.9 or less higher than the refractive index of the first n-type layer (4), and
the refractive index of the second n-type layer (5) is 0.01 or more and 0.9 or less higher than the refractive index of the second transparent electrode (6).

### Embodiment 10.

The solar cell (100) according to any one of Embodiments 1 to 9, wherein
the second n-type layer (5) is in direct contact with the first n-type layer (4) and the second transparent electrode (6).

### Embodiment 11.

The solar cell (100) according to any one of Embodiments 1 to 10, wherein
an average deviation of surface roughness on the side of the second transparent electrode (6) of the second n-type layer (5) is 50 nm or more.

### Embodiment 12.

The solar cell (100) according to any one of Embodiments 1 to 11, wherein
the first n-type layer (4) includes a first layer including an oxide including Ga as a main component and a second layer optionally including Zn oxide,
the first layer is located on the p-type light-absorbing layer (3) side, and
the second layer is located on the second n-type layer (5) side.

### Embodiment 13.

The solar cell (100) according to any one of Embodiments 1 to 12, wherein
the refractive index of the second n-type layer (5) is 2.0 or more and 2.5 or less,
the refractive index of the second transparent electrode (6) is 1.6 or more and 1.99 or less,
the refractive index of the first n-type layer (4) on the second n-type layer (5) side is is 1.6 or more and 1.99 or less,
the refractive index of the second n-type layer (5) is 0.01 or more and 0.9 or less higher than the refractive index of the first n-type layer (4), and
the refractive index of the second n-type layer (5) is 0.01 or more and 0.9 or less higher than the refractive index of the second transparent electrode (6).

### Embodiment 14.

The solar cell (100) according to any one of Embodiments 1 to 13, wherein
the p-type light absorbing layer (3) comprises a compound having a chalcopyrite structure or a cuprous oxide compound.

### Embodiment 15.

The solar cell (100) according to any one of Embodiments 1 to 14, wherein
the p-type light absorbing layer (3) comprises a compound having a chalcopyrite structure or a cuprous oxide compound, and
the p-type light absorbing layer (3) is the thickest semiconductor layer included in the solar cell (100).

### Embodiment 16.

The solar cell (100) according to any one of Embodiments 1 to 15, wherein:
the p-type light absorbing layer (3) comprises a cuprous oxide compound, and
the p-type light absorbing layer (3) is the thickest semiconductor layer included in the solar cell (100).

### Embodiment 17.

The solar cell (100) according to any one of Embodiments 1 to 16, wherein
the p-type light absorbing layer (3) comprises crystals of a cuprous oxide compound having a grain size of five times or more the thickness of the p-type light absorbing layer (3).

## Claims

1. A solar cell (100) comprising, provided on each other in this order:
- a first transparent electrode (2);
- a p-type light absorbing layer (3);
- a first n-type layer (4);
- a second n-type layer (5) comprising a titanium-including metal oxide and having a refractive index which is higher than that of the layer (4);
- a second transparent electrode (6); and
- an anti-reflection layer (7).

2. The solar cell of claim 1, wherein the content of the titanium-including metal oxide in the layer (5) is 50-100 wt.%.

3. The solar cell of claim 1 or 2, wherein the titanium-including metal oxide included in the layer (5) is one or more selected from titanium dioxide, doped titanium dioxide, and doped strontium titanate.

4. The solar cell of any of claims 1-3, wherein
the titanium-including metal oxide included in the layer (5) is one or more selected from titanium dioxide, doped titanium dioxide, and doped strontium titanate, and
the dopant of the doped titanium dioxide and doped strontium titanate is one or more selected from Nb, Ta, Mo, and W.

5. The solar cell of any of claims 1-4, wherein
the titanium content among the metal elements included in the layer (4) is 0-10 atom%, and
the titanium content among the metal elements included in the layer (5) is 45-100 atom%.

6. The solar cell of any of claims 1-5, wherein the thickness of the layer (5) is 1-50 nm.

7. The solar cell of any of claims 1-6, wherein the refractive index of the layer (5) is higher than that of the electrode (6).

8. The solar cell of any of claims 1-7, wherein the refractive index (n1) of the layer (5) and the thickness (d1) of the layer (5) satisfy 2 nm ≤ n1×d1 nm ≤ 125 nm.

9. The solar cell of any of claims 1-8, wherein the refractive index of the layer (5)
- is 0.01-0.9 higher than that of the layer (4), and
- is 0.01-0.9 higher than that of the electrode (6).

10. The solar cell of any of claims 1-9, wherein the layer (5) is in direct contact with the layer (4) and the electrode (6).

11. The solar cell of any of claims 1-10, wherein the average deviation of surface roughness on the side of the electrode (6) of the layer (5) is ≥ 50 nm.

12. The solar cell of any of claims 1-11, wherein the layer (4) includes
- a first layer which includes an oxide including Ga as a main component and is located on the p-type light-absorbing layer (3) side, and
- a second layer which optionally includes Zn oxide, and is located on the layer (5) side.

13. The solar cell of any of claims 1-12, wherein
- the refractive index of the layer (5) is 2.0-2.5,
- the refractive index of the electrode (6) is 1.6-1.99,
- the refractive index of the layer (4) on the layer (5) side is is 1.6-1.99,
- the refractive index of the layer (5) is 0.01-0.9 higher than that of the layer (4), and
- the refractive index of the layer (5) is 0.01-0.9 higher than that of the electrode (6).

14. The solar cell of any of claims 1-13, wherein the layer (3) comprises a compound having a chalcopyrite structure or a cuprous oxide compound, preferably a cuprous oxide compound, and more preferably a cuprous oxide compound having a grain size of ≥ 5 times the thickness of the layer (3).

15. The solar cell of claim 14, wherein the layer (3) is the thickest semiconductor layer included in the solar cell (100).
